**Europäisches Patentamt**

**European Patent Office**

**Office européen des brevets**

(19)

(11) Publication number: **0 244 628 B1**

(12)

# EUROPEAN PATENT SPECIFICATION

(45) Date of publication of the patent specification:
27.12.90

(21) Application number: 87104661.1

(22) Date of filing: 30.03.87

(51) Int. Cl.⁵: **G11C 7/06, G11C 11/34**

(54) Sense amplifier for a semiconductor memory device.

(30) Priority: 31.03.86 JP 73002/86

(43) Date of publication of application:
11.11.87 Bulletin 87/46

(45) Publication of the grant of the patent:
27.12.90 Bulletin 90/52

(84) Designated Contracting States:
DE FR GB

(56) References cited:
EP-A- 0 015 070
EP-A- 0 122 564
EP-A- 0 143 591
DE-A- 2 621 137
US-A- 4 158 241
US-A- 4 421 996
US-A- 4 435 788
US-A- 4 509 147

IEEE Journal of Solid-State Circuits, vol SC-20, no 1,
Feb 1985, New York (US) S Atsumi et al: "Fast
programmable 256K Read Only Memory with On-Chip
Test Circuits", pp 422-427

(73) Proprietor: KABUSHIKI KAISHA TOSHIBA, 72,
Horikawa-cho Saiwai-ku, Kawasaki-shi
Kanagawa-ken 210(JP)
Proprietor: Toshiba Micro-Computer Engineering
Corporation, 2-11, Higashida-cho Kawasaki-ku,
Kawasaki-shi Kanagawa-ken(JP)

(72) Inventor: Atsumi, Shigeru c/o Patent Division, Kabushiki
Kaisha Toshiba 1-1 Shibaura 1-chome, Minato-ku
Tokyo 105(JP)
Inventor: Tanaka, Sumio c/o Patent Division, Kabushiki
Kaisha Toshiba 1-1 Shibaura 1-chome, Minato-ku
Tokyo 105(JP)
Inventor: Otsuka, Nobuaki c/o Patent Division,
Kabushiki Kaisha Toshiba 1-1 Shibaura 1-chome,
Minato-ku Tokyo 105(JP)
Inventor: Kamei, Takashi c/o Patent Division, Kabushiki
Kaisha Toshiba 1-1 Shibaura 1-chome, Minato-ku
Tokyo 105(JP)

(74) Representative: Lehn, Werner, Dipl.-Ing. et al, Hoffmann,
Eitle & Partner Patentanwälte Arabellastrasse 4,
D-8000 München 81(DE)

## Description

This invention relates to a semiconductor memory device, and more particularly, to the improvement of a sense amplifier of a semiconductor memory device used for sensing a change in the threshold voltage of a non-volatile, erasable memory cell contained in an EPROM, for example.

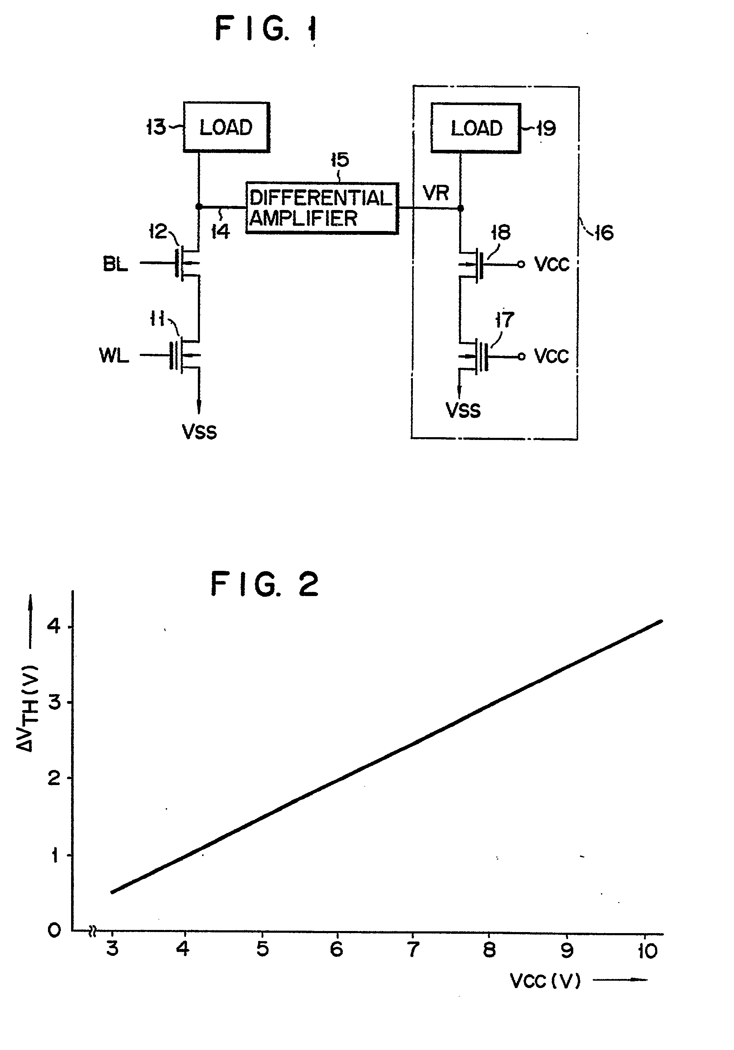

Generally, the sense amplifier for the memory cell of, for example, an EPROM which includes a differential amplifier, has a circuit arrangement as shown in Fig. 1. In this figure, word line WL is connected to the control gate electrode of floating gate transistor 11 operating as a memory cell. Column-select line BL is connected to the gate of MOS transistor 12 operating as a transfer gate. MOS transistor 12 is also connected to load 13. The first input terminal of differential amplifier 15 is connected to a connection point of load 13 and MOS transistor 12 via sense line 14. The second input terminal of differential amplifier 15 is connected to the output terminal of reference potential generator 16 operating as an internal test circuit. Reference potential generator 16 contains dummy cell 17, MOS transistor (transfer gate) 18, and load 19. Dummy cell 17 is the same size as floating gate transistor (transfer gate) 11, and receives, at the gate, power voltage Vcc. Load 19 provides an intermediate level VR between high («H») and low («L») levels on sense line 14.

With such an arrangement, in a write mode, high potential Vpp is applied to the gate of transistor 11. In a read-out mode, power voltage Vcc is applied thereto. Voltages Vpp and Vcc are externally applied through respective terminals.

A shift $\Delta V_{TH}$ in threshold voltage $V_{TH}$ of the sense amplifier changes its value in relation to power voltage Vcc, as is shown in Fig. 2. The sensitivity of the sense amplifier can be expressed by a shift $\Delta V_{TH}$ in the threshold voltage $V_{TH}$ necessary for detecting that data has been stored in a memory cell. In the sense amplifier constructed as shown in Fig. 1, as can be seen from Fig. 2, the shift $\Delta V_{TH}$ in the threshold voltage $V_{TH}$ necessary for detecting the data-stored state of the memory cell is 3V, even when power voltage Vcc is increased to 8V. Shift $\Delta V_{TH}$ is 4V at most, even for 10V of power voltage Vcc. When considering the breakdown voltage of the transistors used in the peripheral circuit of the sense amplifier, it is difficult to set power voltage Vcc at 10V or more. Therefore, it is impossible to monitor a shift $\Delta V_{TH}$ of 4V or more in this threshold voltage.

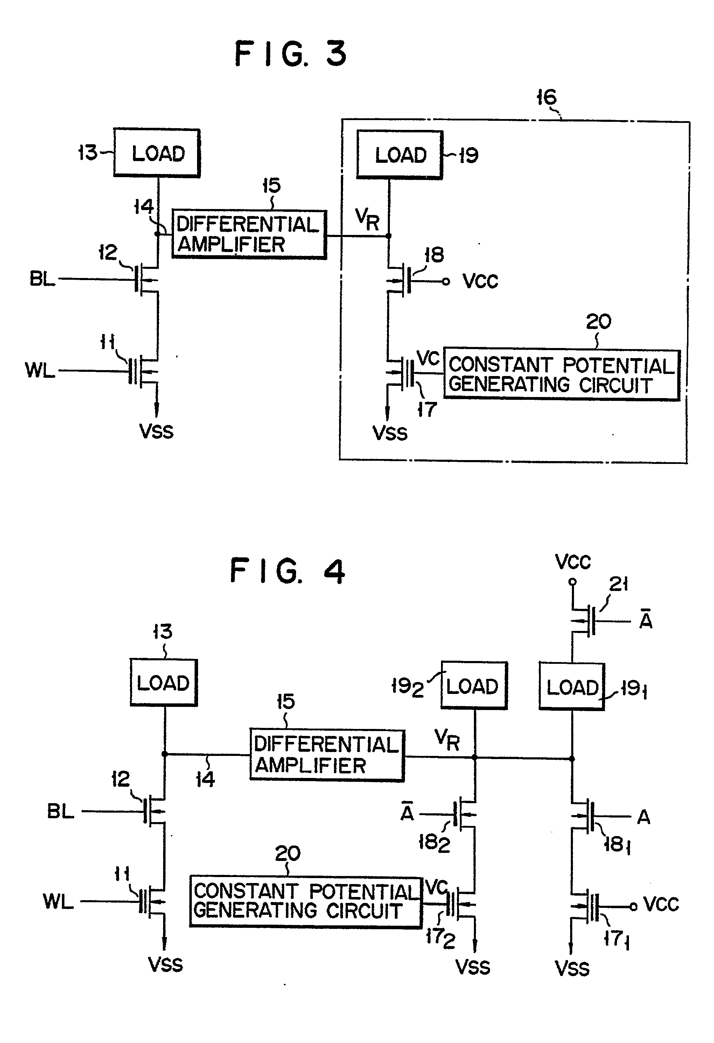

A prior art sense amplifier, which eliminated the above disadvantage, is illustrated in Fig. 3. The Fig. 3 circuit differs from the Fig. 1 circuit only in the following points:

Loads 13 and 19 are designed so as to have the same electrical characteristics. Low voltage Vc, which is not dependent on power voltage Vcc and is lower than the power voltage, is applied to the gate of dummy cell 17 from constant-voltage generator 20, which is formed on the chip of the memory cells.

The sense amplifier shown in Fig. 3 has a circuit arrangement which is symmetrically arrayed with respect to differential amplifier 15. Therefore, a point where mutual conductance gm of memory cell 11 is equal to that of memory cell 17 corresponds to a critical point, where a unit of stored data changes it's level. The current $I_{11}$ flowing through memory cell 11 can be expressed by

$$I_{11} \propto Vcc - V_{TH11} = Vcc - (V_{TH0} + \Delta V_{TH}).$$

where $V_{TH11}$ is the threshold voltage of floating gate transistor (memory cell) 11 when data has been written thereinto, viz., carriers have been injected into the transistor. $V_{TH0}$ is a threshold voltage of the transistor when no data has been written thereinto, viz., no carriers have been injected into the transistor.

The current $I_{17}$ flowing into dummy cell 17 can be expressed by

$$I_{17} \propto Vc - V_{TH0}.$$

The state of the memory cell, i.e., a data-stored state or a non-data-stored state, is detected when $I_{11} = I_{17}$.

At this time, the following relation holds

$$Vcc - (V_{TH0} + \Delta V_{TH}) = Vc - V_{TH0}$$

$$\Delta V_{TH} = V\alpha - Vc.$$

As can be seen from the above, when fixed potential Vc is applied to the gate of dummy cell 17, if power voltage Vcc is changed, the level of the data stored in transistor 11 changes. By detecting the level of power voltage Vcc at this time, a shift $\Delta V_{TH}$ in the threshold voltage $V_{TH}$ of transistor (memory cell) 11 can be determined.

In the prior art shown in Fig. 4, the internal test circuits of the sense amplifier of Figs. 1 and 3 are combined. Either of these test circuits is selected by control signals A and $\overline{A}$ externally applied. Control signal A goes high (Vcc level) in a read-out mode, and goes low when the internal test circuit is used, viz., in a monitor mode. Therefore, when in the read-out mode, MOS transistors 21 and $18_1$ are in an "on" state, and MOS transistor $18_2$ is in an "off" state. Under these conditions, the data read out from dummy cell $17_1$ is subjected to comparison by differential amplifier 15. At this time, loads $19_1$ and $19_2$ operate to provide intermediate potential $V_R$. When shift $\Delta V_{TH}$ of threshold voltage $V_{TH}$ of the memory cell is monitored, control signal A goes low, and transistor $18_2$ is in the "on" state, while transistors 21 and $18_1$ are in the "off" state. Under these conditions, the data read out from dummy cell $17_2$ is compared with the data from transistor (memory cell) 11, by means of differential amplifier 15. At this time, only load $19_2$ operates.

In the device of the type in which high potential is applied to the memory cell (such as an EPROM), in the write mode, the MOS transistor to which high potential Vpp is applied, in the write mode, is designed to have a different structure from the MOS transistor to which normal power voltage Vcc is applied, in the same mode. The high voltage applied to the transistor is such that, in order to withstand the high potential applied thereto, a long channel length or a lightly doped drain (LDD) is employed, so as to increase the breakdown voltage at the surface junction. In the case of the power voltage applied to the transistor, in the course of normal operation, it rarely occurs that an especially high voltage is applied thereto. For this reason, this transistor is designed to have a short channel length. This feature enables transistor to operate at high speed.

With the high packaging density of recent semiconductor devices, the channel length and the junction breakdown voltage of the power voltage applied to the MOS transistor contained in the peripheral circuit of the sense amplifier are respectively shorter and degraded considerably. With the progress made in the microfabrication of these devices, the level of power voltage Vcc applicable to the devices has also decreased. For example, the applicable power voltage Vcc has decreased from 10V to 8V. In the circuit of Fig. 3, the shift $\Delta V_{TH}$ in the threshold voltage $V_{TH}$ of the memory cell is related to power voltage Vcc and the constant voltage Vc from constant voltage generator 20 by $\Delta V_{TH} = Vcc-Vc$, as described above. This relationship indicates that if the applicable power voltage Vcc drops, the shift $\Delta V_{TH}$ which can be monitored is also decreased. In the circuit of Fig. 3, the fixed output potential Vc of constant voltage generator 20 is used. In other words, the output potential Vc as the fixed potential is generated within the chip. This makes it impossible to externally determine an exact value of the shift value $\Delta V_{TH}$ of the selected memory.

The IEEE Journal of Solid-State Circuits, volume SC–20, number 1, 1985, page 422 discloses a fast programmable 256K read only memory with on-chip test circuits. The prior art circuit includes a dummy cell supplied with a constant reference voltage between zero volts and $V_{cc}$. The memory cell is either at $V_{cc}$ or at 0 volts. A differential amplifier compares the level of the memory cell to the level of the dummy cell. If the memory cell voltage is higher then a high signal is output. If the memory cell voltage is lower then a low signal is output. In normal reading operations the cell uses two voltages. The constant voltage and $V_{cc}$. Said prior art circuit also has a voltage higher than $V_{cc}$ which is $V_{CCMAX}$ which is the maximum voltage supply with which the «off» state «cell» can be detected.

Accordingly, an object of this invention is to provide a sense amplifier in a semiconductor memory device with an internal test circuit, which can precisely monitor a shift in the threshold voltage of each memory cell, and even a large shift in the threshold voltage.

To achieve the above object, a semiconductor memory device is provided, comprising a semiconductor memory device, comprising:

a first floating gate transistor (22) operating as a memory cell, whose control gate is connected to a word line, and which is supplied with a high potential from a second power terminal (Vpp) in a test mode, the high potential being higher than a power voltage from a first power terminal (Vcc);

a first MOS transistor (23), operating as a transfer gate for selecting said first floating gate transistor (22);

a first load (24), connected to said first MOS transistor;

a second floating gate transistor (32), operating as a dummy cell, whose control gate is connected to said first power terminal (Vcc);

a second MOS transistor (31), operating as a transfer gate for selecting said second floating gate transistor (32);

a second load (28), connected to said second MOS transistor, the gate of said second MOS transistor (31) being supplied with the high potential from said second power terminal (Vpp) in a test mode;

potential-difference detecting means (26), whose first input terminal is connected to the connection point of said first load (24) and said first MOS transistor (27), and whose second input terminal is connected to the connection point of the second load (28) and the second MOS transistor (31); and

power terminal switching means ( 33, 34, 35, 36 ), whose output terminal is connected to said word line and outputs said high potential from said second power terminal (Vpp) in the test mode, said power terminal switching means (33, 34, 35, 36) selectively applies a potential corresponding to that at said first power terminal (Vcc) and, during the test mode, a potential corresponding to that at said second power terminal (Vpp) to said word line, the gate of said first MOS transistor and said gate of said second MOS transistor.

According to the present invention, in the readout mode, the word line and the column-select line are supplied with a signal corresponding to the potential at the first power terminal. The second MOS transistor is connected, at its gate, to first power terminal. In the write mode, the word line and the column-select line are supplied with a signal corresponding to the potential at the second power terminal. The second MOS transistor is connected, at its gate, to the second power terminal. In the test mode, the word line, the column-select line, and the gate of the second MOS transistor are connected to the second power terminal. By externally applying a voltage to the second power terminal, a shift in the threshold voltage of the first floating gate transistor is monitored.

According to the present invention, in the write mode, a high potential is applied to the word line and the column-select line. When the internal test circuit is used, that is, when the shift in the threshold voltage of the first floating gate transistor is monitored, the first floating gate transistor and the first MOS transistor can be connected, at their gates, to the second power terminal of the high potential. At this time, the potential applied from the second power terminal is gradually increased from low to high. When it reaches a predetermined level, and the data is changed from "0" (data-stored state) to "1" (non-data-stored state), the potential at that time is measured, and the shift in the threshold voltage of the memory cell can thus be determined.

Since a high potential must be applied to the word line and the column-select line, the MOS transistors constituting the row and column decoders are structured so as to be able to withstand high voltages. This feature allows a high potential to be applied to the first MOS transistor, even when the internal test circuit is used. It also enables the shift $V_{TH}$ to be monitored throughout a wider range.

This invention can be more fully understood from the following detailed description when taken in conjunction with the accompanying drawings, in which:

Fig. 1 shows a circuit diagram of a prior art sense amplifier;

Fig. 2 shows a graph illustrating a relationship between a shift $V_{TH}$ of the threshold voltage of the memory cell in the sense amplifier of Fig. 1, and power voltage Vcc;

Fig. 3 shows a circuit diagram of another prior art sense amplifier using a constant voltage generator as a reference voltage generator;

Fig. 4 shows a circuit diagram of a further prior art sense amplifier, in which the reference voltage generators shown in the circuits of Figs. 1 and 3 are combined;

Fig. 5 shows a circuit diagram of a sense amplifier of a semiconductor memory device according to an embodiment of the present invention;

Figs. 6A and 6B show circuit diagrams of circuits for applying power voltage Vcc and high potential Vpp to the memory cell and the MOS transistor of the sense amplifier of Fig. 5; and

Fig. 6C shows a circuit diagram of a modification of the circuit of Fig. 6B.

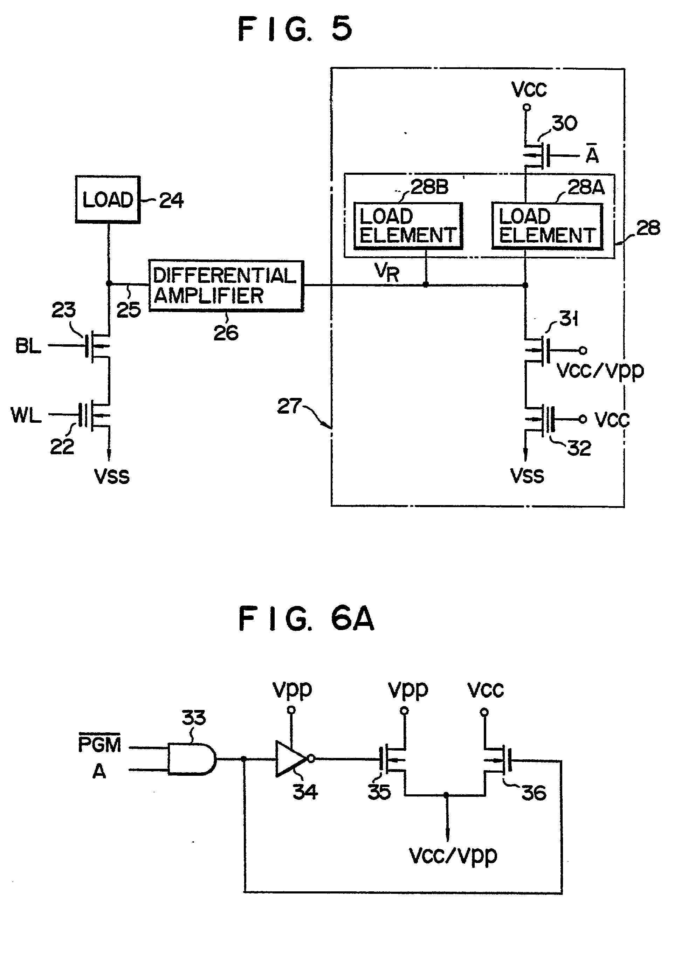

An embodiment of the present invention will now be described, with reference to the accompanying drawings. In Fig. 5, the control gate of floating gate transistor 22, operating as a memory cell, is connected to word line WL. One end of floating gate transistor 22 is connected to earth point Vss. The other end of transistor 22 is connected to the first end of MOS transistor 23 which operates as a transfer gate. The gate of MOS transistor 23 is connected to column-select line BL. The second end of MOS transistor 23 is connected to load 24. The connection point of load 24 and MOS transistor 23 is connected to the first input terminal of differential amplifier 26 via sense line 25. The second input terminal of differential amplifier 26 is connected to the output terminal of reference potential generator 27 as an internal test circuit. Reference potential generator 27 comprises load 28, MOS transistor 30, MOS transistor 31, and floating gate transistor 32. Load 28 is composed of load elements 28A and 28B which are connected to the second input terminal of differential amplifier 26. MOS transistor 30 performs switching operation when it is supplied with control signal $\overline{A}$, and decides whether or not load element 28A is connected to the input terminal of differential amplifier 26. MOS transistor 31 is applied at the gate with power voltage Vcc (in the read-out mode) or high voltage Vpp (in the write mode and when the internal test circuit is used), and operates as a transfer gate. Floating gate transistor 32 is applied at the gate with power voltage Vcc. Floating gate transistor 32 operates as a dummy cell. Column select line BL and word line WL are supplied with a signal of the Vcc system in the read-out mode, and with a signal of the Vpp system in the write mode or when the internal test circuit is used. Load 24 and load element 28 have the same electrical characteristics. Reference numeral 46 designates Vpp level voltage generator. When the internal test circuit is used, that is, the shift amount of threshold voltage of floating gate transistor 22 is monitored, Vpp level voltage generator 26 applies floating gate transistor 22 and MOS transistor 23 with the potential of a level that corresponds to high voltage Vpp. In this case, application of the voltage is made by gradually increasing that voltage.

The operation will now be given. When the internal test circuit is used, control signal $\overline{A}$ is "H" in level, and MOS transistor 30 is turned off. Since load 24 and load element 28B have the same electrical characteristics, the sense amplifier has a circuit arrangement which is symmetrical arrayed with respect to both the input terminals of differential amplifier 26. Therefore, current $I_{22}$ flowing through floating gate transistor (memory cell) when the internal test circuit is used, is

$I_{22} \propto Vpps - V_{TH22}$

$= Vpps - (V_{TH0} + \Delta V_{TH})$

where Vpps is a voltage applied from Vpp level voltage generator 46, $V_{TH22}$ a threshold voltage of transistor 22 when data is written into transistor 22 as a memory cell, and $V_{TH0}$ a threshold voltage of transistor 22 when no data is written into transistor 22.

Current $I_{32}$ flowing through dummy cell 32 is

$I_{32} \propto Vcc - V_{TH32}$

$= Vcc - V_{TH0}.$

As described above, when $I_{22} = I_{32}$, the potential at the connection point of load 24 and MOS transistor 23, and reference potential $V_R$ of reference potential generator 27 are equal to each other with respect to differential amplifier 26. At this time, the following relation holds.

$Vpps - (V_{TH0} + \Delta V_{TH}) = Vcc - V_{TH0}$

The potential applied to floating gate transistor 22 and MOS transistor 23 from Vpp level voltage generator 46 is gradually increased in level, and when the data of transistor 22 is changed, viz., when the logical state of the output signal of differential amplifier 26 is changed, potential Vpps is read. At this time, one can read the shift amount (write amount) $\Delta V_{TH}$, accurately.

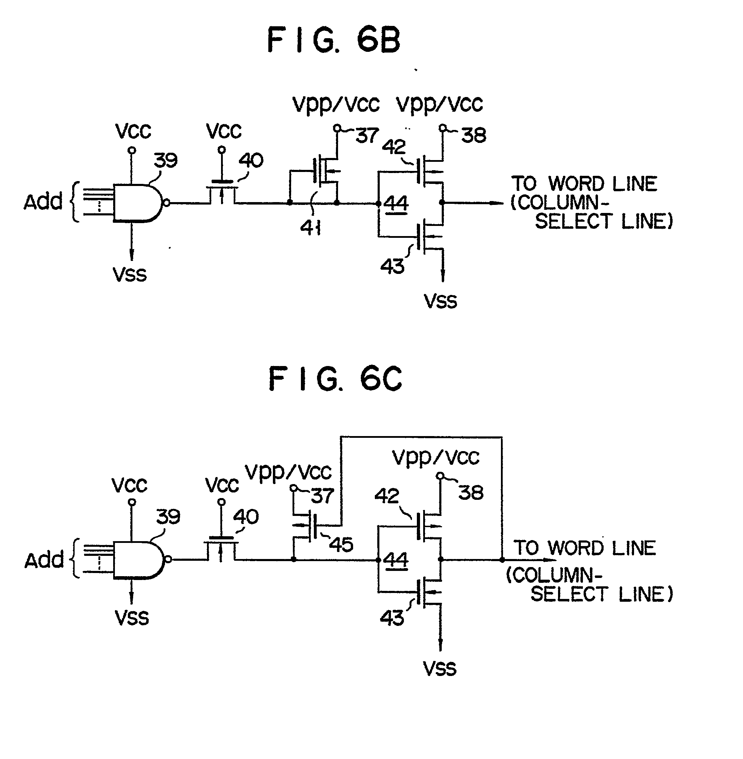

Figs. 6A and 6B show a configuration of a circuit for selectively applying power voltage Vcc and high voltage Vpp to floating gate transistor 22 (memory cell) and MOS transistor 31 in the sensor amplifier of Fig. 5.

Fig. 6A shows a circuit for selecting power voltage Vcc and high voltage Vpp. Control signals $\overline{PGM}$ and A are applied to AND gate 33. In the write mode, control signal PGM goes high. When the internal test circuit is used, control signal A goes low. The output signal of AND gate 33 is supplied to inverter 34. Inverter 34 inverts the input signal of the Vcc system and outputs its inverted signal of the Vpp system. The signal at the output terminal of inverter 34 is supplied to the gate of MOS transistor 35, which is coupled at the first terminal with MOS transistor 35. The signal of the output terminal of AND gate 33 is supplied to the gate of MOS transistor 36, which is coupled at the first terminal of MOS transistor 36. At the connection point of the second terminals of MOS transistors 35 and 36, power voltage 35 or high voltage Vpp appears, which depends on control signals $\overline{PGM}$ and A. The select output is supplied to terminals 37 and 38 of row decoder (column decoder) shown in Fig. 6B. The row decoder comprises NAND gate 39, MOS transistor 40, depletion type MOS transistor 41, and CMOS inverter 44. NAND gate 39 is supplied with address signal Add. MOS transistor 40 is supplied at the first end with the output signal of NAND gate 39, and is made conductive by power voltage Vcc. Depletion type MOS transistor 41 is connected to the second terminal of MOS transistor 40 and to terminal 37. CMOS converter 44 is made up of MOS transistors 42 and 43 connected in series between earth point Vss and terminal 38. The input terminal of CMOS converter 44 is connected to the second end of MOS transistor 40. The output signal of CMOS inverter 44 is supplied to word line WL.

With such an arrangement, in the write mode, word line WL and column select line BL are applied with high voltage Vpp. In the read-out mode, these lines are applied with power voltage Vcc. When the internal test circuit is used, the gate of MOS transistor 31 is connected to high voltage Vpp. Vpp level voltage generator 46 applies a potential corresponding to high voltage Vpp to floating gate transistor 22 and MOS transistor 23. At this time, the potential applied by Vpp level potential generator 46 is gradually increased. When the potential reaches a predetermined level, the data stored in transistor 22 is changed from "0" data of data storage state to "1" data of non-data storage state, if measuring the potential applied from Vpp level voltage generator 46, one can know a shift of the threshold voltage of the memory cell by using the equation $Vpps - Vcc = \Delta V_{TH}$. In the row decoder (column decoder) shown in Fig. 6B, depletion type MOS transistor 41 is used. As an alternative, enhancement type MOS transistor 45 may be used. In this case, as shown in Fig. 6C, enhancement type MOS transistor 45 is connected between terminal 37 and MOS transistor 40. MOS transistor 45 is controlled by CMOS inverter 44.

**Claims**

1. A semiconductor memory device, comprising:
a first floating gate transistor (22) operating as a memory cell, whose control gate is connected to a word line, and which is supplied with a high potential from a second power terminal (Vpp) in a test mode, the high potential being higher than a power voltage from a first power terminal (Vcc);
a first MOS transistor (23), operating as a transfer gate for selecting said first floating gate transistor (22);
a first load (24), connected to said first MOS transistor;
a second floating gate transistor (32), operating as a dummy cell, whose control gate is connected to said first power terminal (Vcc);
a second MOS transistor (31), operating as a transfer gate for selecting said second floating gate transistor (32);
a second load (28), connected to said second MOS transistor, the gate of said second MOS transistor (31) being supplied with the high potential from said second power terminal (Vpp) in a test mode;
potential-difference detecting means (26), whose first input terminal is connected to the connection point of said first load (24) and said first MOS transistor (27), and whose second input terminal is connected to the connection point of the second load (28) and the second MOS transistor (31); and
power terminal switching means (33, 34, 35, 36), whose output terminal is connected to said word line and outputs said high potential from said second power terminal (Vpp) in the test mode, said power terminal switching means (33, 34, 35, 36) selectively applies a potential corresponding to that at said first power terminal (Vcc) and, during the test mode, a potential corresponding to that at said second power terminal (Vpp) to said word line, the gate of said first MOS transistor (23) and said gate of said second MOS transistor.

2. The sense amplifier for a semiconductor memory device according to claim 1, characterized by:
the gate of said first MOS transistor (23) being connected to a column-select line, and being supplied with the high potential from said second power terminal in the test mode.

3. The sense amplifier for a semiconductor memory device according to claim 1, characterized in that:
the gate of said first MOS transistor (23) is connected to a column-select line.

4. The sense amplifier for a semiconductor memory device according to claim 1, characterized by, said potential corresponding to that at a second power terminal (Vpp) being applied to said first floating gate transistor (22), for supplying a potential higher than the power voltage supplied from a first power terminal (Vcc);
the gate of said first MOS transistor (23) being connected to a column-select line, to which is applied said potential corresponding to that at the second power terminal (Vpp), for supplying the potential higher than the power voltage supplied from the first power terminal (Vcc) and;
the gate of said second MOS transistor (31) being selectively connected to said first power terminal (Vcc) or said second power terminal (Vpp) by said power terminal switching means (33, 34, 35, 36), and a differential amplifier (26) whose first input terminal is connected to the connection point of said first load (24) and said first MOS transistor, and whose second input terminal is connected to the connection point of said second load (28) and second MOS transistor (32).

5. A sense amplifier for a semiconductor memory device according to claim 1, 2, 3 or 4, characterized by means (39, 40, 41, 44) for applying, in a data-write mode, the high potential from said second power terminal (Vpp) to the gate of said second MOS transistor (31), and for supplying a signal corresponding to a potential at the second power terminal (Vpp), to the gates of said first MOS transistor (23) and said first floating gate transistor (22), via the word line and the column-select line.

6. A sense amplifier for a semiconductor memory device according to claim 1, 2, 3 or 4, characterized in that the potential at the connection point of said second load (28) and said second MOS transistor (32) is a constant potential.

7. A sense amplifier for a semiconductor memory device according to claim 4, characterized by means for gradually increasing the potential at said second power terminal (Vpp) when a shift in the threshold voltage of said first floating gate transistor (22) is monitored, whereby upon a change in the level of the data stored in said first floating gate transistor (22), said potential is detected by said differential amplifier (27).

8. A sense amplifier for a semiconductor memory device according to claim 4 or 7, characterized by means (46) for gradually increasing the potential corresponding to that at said second power terminal (Vpp).

9. A sense amplifier for a semiconductor memory device according to any one of the above claims, characterized in that said second load (28) includes first and second load elements (28A) and (28B), said first load element (28A) being turned off when the shift in the threshold voltage of said first floating transistor (22) is monitored, and said second load element (28B) being connected to said second MOS transistor (32), in parallel with said first load element (28A).

10. A sense amplifier for a semiconductor memory device according to claim 9, characterized in that said first load element (28A) is supplied with the power voltage via a third MOS transistor (30) which is turned off when the amount of shift in the threshold voltage of said first floating gate transistor (22) is monitored.

11. A sense amplifier for a semiconductor memory device according to claim 9 or 10, characterized in that said first load (24) and said second load element (28B) of said second load have the same electrical characteristics.

**Patentansprüche**

1. Halbleiterspeichereinrichtung mit:
einem ersten Transistor (22) mit schwebendem Gate, als Speicherzelle arbeitend, dessen Steuergate an eine Wortleitung angeschlossen ist und welchem in einem Testmodus ein hohes Potential von einem zweiten Leistungsanschluß (Vpp) zugeführt wird, wobei das hohe Potential höher als die Versorgungsspannung von einem ersten Leistungsanschluß (Vcc) ist;
einem ersten MOS-Transistor (23), der als Übertragungsgate zum Auswählen des ersten Transistors (22) mit schwebendem Gate arbeitet;

einer ersten an den ersten MOS-Transistor angeschlossenen Last (24);
einem zweiten Transistor (32) mit schwebendem Gate, als Blindzelle arbeitend, dessen Steuergate an den ersten Leistungsanschluß (Vcc) angeschlossen ist;
einem zweiten MOS-Transistor (31), der als Übertragungsgate zum Auswählen des zweiten Transistors (32) mit schwebendem Gate arbeitet;
einer zweiten an den zweiten MOS-Transistor angeschlossenen Last (28), wobei dem Gate des zweiten MOS-Transistors (31) in einem Testmodus das hohe Potential des zweiten Leistungsanschlusses (Vpp) zugeführt wird;
einer Potentialdifferenz-Erfassungseinrichtung (26), deren erster Eingangsanschluß an den Verbindungspunkt der ersten Last (24) und des ersten MOS-Transistors (27) angeschlossen ist, und deren zweiter Eingangsanschluß an den Verbindungspunkt der zweiten Last (28) und des zweiten MOS-Transistors (31) angeschlossen ist; und
einer Leistungsanschlußschalteinrichtung (33, 34, 35, 36), deren Ausgangsanschluß an die Wortleitung angeschlossen ist und im Testmodus das hohe Potential vom zweiten Leistungsanschluß (Vpp) ausgibt, wobei die Leistungsanschlußschalteinrichtung (33, 34, 35, 36) selektiv ein Potential entsprechend dem an dem ersten Leistungsanschluß (Vcc) und während des Testmodus ein Potential entsprechend dem am zweiten Leistungsanschluß (Vpp) an die Wortleitung, das Gate des ersten MOS-Transistors (23) und das Gate des zweiten MOS-Transistors anlegt.

2. Leseverstärker für eine Halbleiterspeichereinrichtung nach Anspruch 1, dadurch gekennzeichnet, daß das Gate des ersten MOS-Transistors (23) an eine Spaltenauswahlleitung angeschlossen ist, und daß dem Gate im Testmodus das hohe Potential des zweiten Leistungsanschlusses zugeführt wird.

3. Leseverstärker für eine Halbleiterspeichereinrichtung nach Anspruch 1, dadurch gekennzeichnet, daß das Gate des ersten MOS-Transistors (23) an eine Spaltenauswahlleitung angeschlossen ist.

4. Leseverstärker für eine Halbleiterspeichereinrichtung nach Anspruch 1, dadurch gekennzeichnet, daß das Potential entsprechend dem am zweiten Leistungsanschluß (Vpp) dem ersten Transistor (22) mit schwebendem Gate zugeführt wird, um ein Potential zu liefern, das höher als die vom ersten Leistungsanschluß (Vcc) gelieferte Versorgungsspannung ist;
das Gate des ersten MOS-Transistors (23) an eine Spaltenauswahlleitung angeschlossen ist, auf die das Potential entsprechend dem am zweiten Leistungsanschluß (Vpp) gegeben ist, um das Potential zu liefern, das höher als die von dem ersten Leistungsanschluß (Vcc) zugeführte Versorgungsspannung ist; und
das Gate des zweiten MOS-Transistors (31) selektiv an den ersten Leistungsanschluß (Vcc) oder den zweiten Leistungsanschluß (Vpp) durch die Leistungsanschlußschalteinrichtung (33, 34, 35, 36) angeschlossen ist, und ein erster Eingangsanschluß eines Differenzverstärkers (26) an den Verbindungspunkt der ersten Last (24) und des ersten MOS-Transistors angeschlossen ist, und dessen zweiter Eingangsanschluß an den Verbindungspunkt der zweiten Last (28) und des zweiten MOS-Transistors (32) angeschlossen ist.

5. Leseverstärker für eine Halbleiterspeichereinrichtung nach Anspruch 1, 2, 3 oder 4, gekennzeichnet durch eine Einrichtung (39, 40, 41, 44) zum Zuführen des hohen Potentials von dem zweiten Leistungsanschluß (Vpp) an das Gate des zweiten MOS-Transistors (31) in einem Datenschreibmodus, und zum Zuführen eines Signals entsprechend einem Potential am zweiten Leistungsanschluß (Vpp) an die Gates des ersten MOS-Transistors (23) und des ersten Transistors (22) mit schwebendem Gate über die Wortleitung und die Spaltenauswahlleitung.

6. Leseverstärker für eine Halbleiterspeichereinrichtung nach Anspruch 1, 2, 3 oder 4, dadurch gekennzeichnet, daß das Potential am Verbindungspunkt der zweiten Last (28) und des zweiten MOS-Transistors (32) ein konstantes Potential ist.

7. Leseverstärker für eine Halbleiterspeichereinrichtung nach Anspruch 4, gekennzeichnet durch eine Einrichtung zum schrittweisen Steigern des Potentials am zweiten Leistungsanschluß (Vpp), wenn eine Verschiebung in der Schwellenspannung des ersten Transistors (22) mit schwebendem Gate gemeldet wird, wodurch auf eine Veränderung im Pegel der im ersten Transistor (22) mit schwebendem Gate gespeicherten Daten das Potential durch den Differenzverstärker (27) erfaßt wird.

8. Leseverstärker für eine Halbleiterspeichereinrichtung nach Anspruch 4 oder 7, gekennzeichnet durch eine Einrichtung (46) zum graduellen Steigern des Potentials entsprechend dem am zweiten Leistungsanschluß (Vpp).

9. Leseverstärker für eine Halbleiterspeichereinrichtung nach einem der vorhergehenden Ansprüche, dadurch gekennzeichnet, daß die zweite Last (28) erste und zweite Lastelemente (28A) und (28B) enthält, wobei das erste Lastelement (28A) abgeschaltet wird, wenn die Verschiebung in der Schwellenspannung des ersten Transistors (22) mit schwebendem Gate gemeldet wird, und das zweite Lastelement (28B) an den zweiten MOS-Transistor (32) parallel zu dem ersten Lastelement (28A) angeschlossen ist.

10. Leseverstärker für eine Halbleiterspeichereinrichtung nach Anspruch 9, dadurch gekennzeichnet, daß dem ersten Lastelement (28) die Versorgungsspannung über einen dritten MOS-Transistor (30) zugeführt wird, welcher abgeschaltet wird, wenn der Betrag der Verschiebung in der Schwellenspannung des ersten Transistors (22) mit schwebendem Gate gemeldet wird.

11. Leseverstärker für eine Halbleiterspeichereinrichtung nach Anspruch 9 oder 10, dadurch gekennzeichnet, daß die erste Last (24) und das zweite Lastelement (28B) der zweiten Last die gleichen elektrischen Eigenschaften haben.

## Revendications

1. Dispositif de mémoire à semiconducteur, comprenant:
un premier transistor à grille flottante (22) fonctionnant comme une cellule de mémoire, dont la grille de commande est connectée à un fil de mot, et auquel est appliqué un potentiel haut par une deuxième borne de tension d'alimentation (Vpp) dans un mode de test, le potentiel haut étant supérieur à une tension d'alimentation provenant d'une première borne de tension d'alimentation (Vcc);
un premier transistor à métal-oxyde-semiconducteur MOS (23), fonctionnant comme une porte de transfert pour sélectionner le premier transistor à grille flottante (22);
une première charge (24), connectée au premier transistor MOS;
un deuxième transistor à grille flottante (32), fonctionnant comme une cellule fictive, dont la grille de commande est connectée à la première borne de tension d'alimentation (Vcc);
un deuxième transistor MOS (31), fonctionnant comme une porte de transfert pour sélectionner le deuxième transistor à grille flottante (32);
une deuxième charge (28), connectée au deuxième transistor MOS, la grille du deuxième transistor MOS (31) recevant le potentiel haut de la deuxième borne de tension d'alimentation (Vpp) dans un mode de test;
un moyen détecteur de différence de potentiel (26) dont une première borne d'entrée est connectée au point de connexion de la première charge (24) et du premier transistor MOS (27), et dont une deuxième borne d'entrée est connectée au point de connexion de la deuxième charge (28) et du deuxième transistor MOS (31); et
un moyen commutateur de borne de tension d'alimentation (33, 34, 35, 36), dont la borne de sortie est connectée au fil de mot et engendre en sortie le potentiel haut provenant de la deuxième borne de tension d'alimentation (Vpp) dans le mode de test, le moyen commutateur de borne de tension d'alimentation (33, 34, 35, 36) appliquant sélectivement, un potentiel correspondant à celui de la première borne de tension d'alimentation (Vcc) et, pendant le mode de test, un potentiel correspondant à celui à la deuxième borne de tension d'alimentation (Vpp), au fil de mot, à la grille du premier transistor MOS (23) et à la grille du deuxième transistor MOS.

2. Amplificateur de détection pour dispositif de mémoire à semiconducteur selon la revendication 1, caractérisé par:
la grille du premier transistor MOS (23) qui est connectée à un fil de sélection de colonne, et qui reçoit le potentiel haut de la deuxième borne de tension d'alimentation dans le mode de test.

3. Amplificateur de détection pour dispositif de mémoire à semiconducteur selon la revendication 1, caractérisé en ce que:
la grille du premier transistor MOS (23) est connectée à un fil de sélection de colonne.

4. Amplificateur de détection pour dispositif de mémoire à semiconducteur selon la revendication 1, caractérisé par:

le potentiel correspondant à celui à la deuxième borne de tension d'alimentation (Vpp) qui est appliqué au premier transistor à grille flottante (22), pour fournir un potentiel supérieur à la tension d'alimentation fournie par la première borne de tension d'alimentation (Vcc);

la grille du premier transistor MOS (23) qui est connectée à un fil de sélection de colonne, à laquelle est appliqué le potentiel correspondant à celui à la deuxième borne de tension d'alimentation (Vpp), pour fournir le potentiel supérieur à la tension d'alimentation fournie par la première borne de tension d'alimentation (Vcc) et;

la grille du deuxième transistor MOS (31) qui est connectée sélectivement à la première borne de tension d'alimentation (Vcc) ou à la deuxième borne de tension d'alimentation (Vpp) par le moyen commutateur de borne de tension d'alimentation (33, 34, 35, 36); et

un amplificateur différentiel (26) dont une première borne d'entrée est connectée au point de connexion de la première charge (24) et du premier transistor MOS, et dont une deuxième borne d'entrée est connectée au point de connexion de la deuxième charge (28) et du deuxième transistor MOS (32).

5. Amplificateur de détection pour dispositif de mémoire à semiconducteur selon l'une quelconque des revendications 1 à 4, caractérisé par:
un moyen (39, 40, 41, 44) pour appliquer, dans un mode d'écriture de données, le potentiel haut de la deuxième borne de tension d'alimentation (Vpp) à la grille du deuxième transistor MOS (31), et pour fournir un signal correspondant au potentiel à la deuxième borne de tension d'alimentation (Vpp), aux grilles du premier transistor MOS (23) et du premier transistor à grille flottante (22), par l'intermédiaire du fil de mot et du fil de sélection de colonne.

6. Amplificateur de détection pour dispositif de mémoire à semiconducteur selon l'une quelconque des revendications 1 à 4, caractérisé en ce que le potentiel au point de connexion de la deuxième charge (28) et du deuxième transistor MOS (32) est un potentiel constant.

7. Amplificateur de détection pour dispositif de mémoire à semiconducteur selon la revendication 4, caractérisé par un moyen pour augmenter progressivement le potentiel à la deuxième borne de tension d'alimentation (Vpp) quand un décalage de la tension de seuil du premier transistor à grille flottante (22) est contrôlé, le potentiel étant ainsi détecté par l'amplificateur différentiel (27) lors d'une variation du niveau de la donnée mémorisée dans le premier transistor à grille flottante (22).

8. Amplificateur de détection pour dispositif de mémoire à semiconducteur selon l'une quelconque des revendications 4 et 7, caractérisé par un moyen (46) pour augmenter progressivement le potentiel correspondant à celui de la deuxième borne de tension d'alimentation (Vpp).

9. Amplificateur de détection pour dispositif de mémoire à semiconducteur selon l'une quelconque des revendications 1 à 8, caractérisé en ce que la deuxième charge (28) comprend des premier et deuxième éléments de charge (28A et 28B), le premier élément de charge (28A) étant bloqué quand le décalage de la tension de seuil du premier transistor à grille flottante (22) est contrôlé, et le deuxième élément de charge (28B) étant connecté au deuxième transistor MOS (32) en parallèle avec le premier élément de charge (28A).

10. Amplificateur de détection pour dispositif de mémoire à semiconducteur selon la revendication 9, caractérisé en ce que le premier élément de charge (28A) reçoit la tension d'alimentation par l'intermédiaire d'un troisième transistor MOS (30) qui est bloqué quand la quantité de décalage de la tension de seuil du premier transistor à grille flottante (22) est contrôlée.

11. Amplificateur de détection pour dispositif de mémoire à semiconducteur selon l'une quelconque des revendications 9 et 10, caractérisé en ce que la première charge (24) et le deuxième élément de charge (28B) de la deuxième charge ont les mêmes caractéristiques électriques.

# F I G. 1

LOAD — 13

LOAD — 19

DIFFERENTIAL AMPLIFIER — 15

VR

16

12

BL

14

18 — VCC

11

WL

17 — VCC

VSS

VSS

# F I G. 2

$\Delta V_{TH}(V)$

VCC (V)

EP 0 244 628 B1

# FIG. 3

# FIG. 4

# F I G. 5

# F I G. 6A

# F I G. 6B

# F I G. 6C